# EUROPEAN PATENT APPLICATION

(11) **EP 0 740 438 A1**
(43) Date of publication of application: **30.10.1996**
(21) Application number: 94918549.0
(22) Date of filing: 22.06.1994
(51) Int. Cl.: H04L 7/00, H04L 1/00

(54) **METHOD AND APPARATUS FOR DETECTING CYCLIC CODE**

(30) Priority: 30.06.1993 JP 186622/93
(71) Applicant: TOYO COMMUNICATION EQUIPMENT CO. LTD., Kouza-gun, Kanagawa 253-01 (JP)
(72) Inventor: YANAGISAWA, Shigeki Toyo Comm. Equipment Co. Ltd., Kouza-gun Kanagawa 253-01 (JP); MORIZUMI, Tetsuya Toyo Comm. Equipment Co.Ltd., Kouza-gun, Kanagawa 253-01 (JP)
(74) Representative: Skone James, Robert Edmund
(86) International application number: PCT/JP94/00998
(87) International publication number: WO 95/01683

(57) **Abstract**

Before dividing by a generated polynomial a bit string inputted on the receiving side, the remainder added in advance on the transmitting side and produced by the division by the generated polynomial is subtracted in order to detect a cyclic code or simplified cyclic code of n bits included in the bit string. Exclusive-OR circuits (12) are inserted between the first and second stages, between the fifth and sixth stages, and between the sixth and seventh stages of a divider (1). The output of the last stage of a shift register (10) is inputted into the added exclusive-OR circuits (12). A decoder (11) detects that all the bit values in each of the registers of the divider (1) are zero or form a specific pattern. There is no need of providing any high-speed circuit. The delimiter positions of the cyclic code or simplified cyclic code can be found by use of a simple circuit. Particularly, therefore, this method is conveniently applicable to cell synchronization of a high-speed ATM communication system.

## Description

### BACKGROUND OF THE INVENTION

### a) Field of the Invention

This invention relates to a method and device for detecting a cyclic code, and more specifically to means for establishing cell synchronization in the ATM communication system which uses a cyclic code for coding data.

### b) Background Art

ATM (Asynchronous Transmission Mode), which is attracting attention as the switching system for broad-band ISDN (Integrated Services Digital Network), is a system that transmits data containing audio and visual information at a high speed by dividing it into a predetermined length of blocks called cells and adding to them a header which contains the destination.

In this ATM, a cell used for transmitting data consists of 5 bytes for the header and 48 bytes for the information field, 53 bytes in total, for example. Further, in this example, the 5 bytes or 40 bits of the header is a shortened cyclic code which consists of a 32-bit information point and an 8-bit check point called HEC (Header Error Control). Specifically, the generating polynominal of the shortened cyclic code is X⁸ + X² + X + 1, and the header is formed by adding X⁶ + X⁴ + X² + 1 (bit pattern 01010101) to the shortened cyclic code.

In ATM, breakpoints between cells must be detected to correctly receive cells continuously transmitted on a transmission line at the receiving side. This process is called cell synchronization and generally performed by utilizing the header of cells.

Specifically, since a shortened cyclic code can be divided by the generating polynominal without a remainder, X⁶ + X⁴ + X² + 1 added to the header at the transmitting side is obtained as the remainder of division of the 40 bits of the header by the generating polynominal at the receiving side as described above, and this principle is utilized.

When the receiver is completely out of synchronization with receive data (hunting state), it takes the latest 40 bits out of the received data shifting by one bit, performs the division, and enters the pre-synchronized state (quasi-synchronized state) considering that 40 input bits to be the header of a cell if the remainder of the division is X⁶ + X⁴ + X² + 1.

If the remainder is not the added bit pattern, the receiver performs the same test on the next 40 bits at the position shifted by one bit. The receiver repeats this test until it enters the pre-synchronized state. After the receiver has entered the pre-synchronized state, it tests HEC at the position expected to be the header of the next cell a predetermined times, and determines that a complete synchronization has been established.

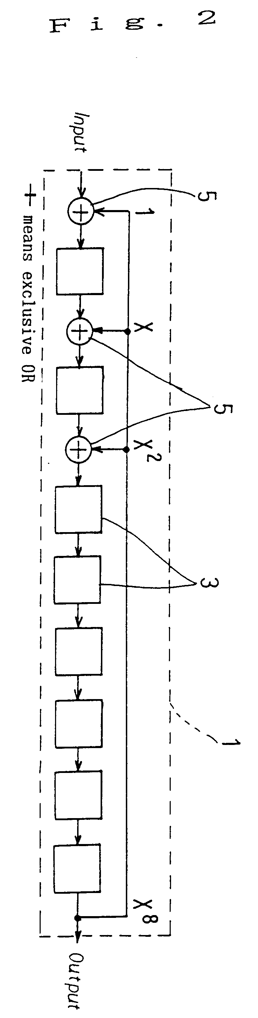

Next, the detection of cell synchronization explained above is more specifically described below. First, an 8-bit feedback shift register as shown in Figure 2 which is used as the divider 1 is described. The output of each register 3 just when 40 bits of received data has been input to the divider 1 formed of this 8-bit feedback shift register is the remainder. The calculation performed here is all operation on binary digits. Therefore, the adders 5 indicate exclusive OR circuits, and both addition and subtraction are equivalent to the exclusive OR operation.

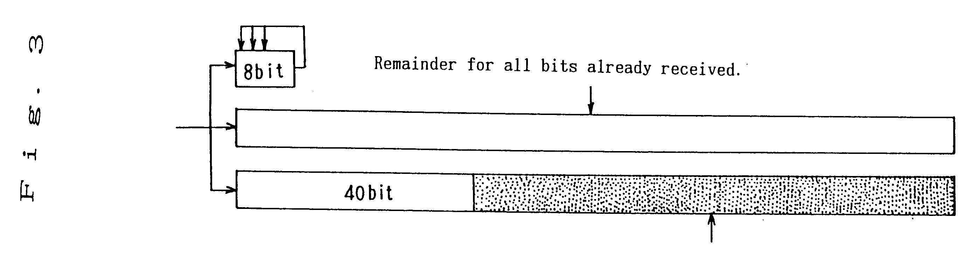

When data is serially received bit by bit and the first 40 bits of the received data are input to the divider, the remainder of the division on 40 bits is obtained. When the next one bit is input, however, the remainder held by the divider becomes the remainder of the division on 41 bits, not the desired remainder of the next 40 bits, as shown in Figure 3. Therefore, to always obtain the latest remainder, the method must be such that the remainder is not affected by the preceding bits.

As the method for always obtaining the remainder of the division on 40 bits, the following two methods can be thought of.

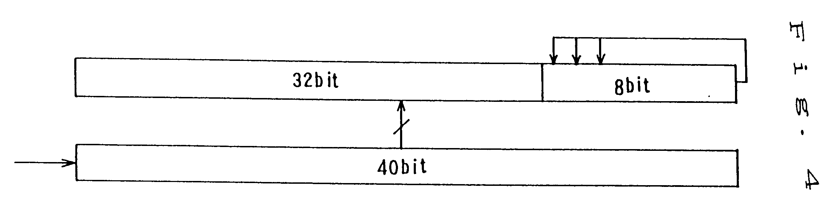

The first method is to form a 40-bit shift register by connecting a 32-bit shift register and the divider 1 in series, load this 40-bit shift register with the latest 40 bits in parallel each time one bit of data is input, perform the division on the 40 bits, and detect the output, as shown in Figure 4.

In this method, however, the shift register is required to operate 32 times as fast as the transmission rate on transmission line. Such a high speed operation is very difficult especially in wide-band ISDN which uses a high speed transmission. Moreover, in high-speed circuits, it is very difficult to transfer 40 bits of data in parallel at the same timing, and separate adjustment for each stage is often required.

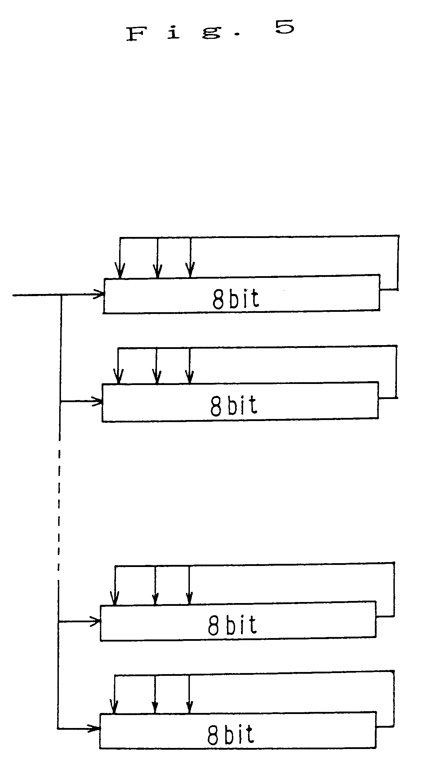

Another method is to connect 40 dividers, each constructed so as to be cleared every time when 40 bits are input, in parallel, input data serially to these 40 dividers clearing them at the timing staggered by one bit from each other in turn, and test the output of the divider the data fed to which has reached 40 bits, as shown in Figure 5.

This ATM cell synchronization method, however, has a problem that 40 dividers are needed and hence the size of the circuit becomes large.

Data transmission using a cyclic code or shortened cyclic code is used not only in ATM, but also in various fields, and there is also the same problem in the detection of a cyclic code or certain portions in data bit sequence by utilizing a cyclic code.

This invention was made to solve the above described problem in conventional cyclic code detection and ATM cell synchronization, and the object of this invention is to provide a method and device for detecting the position of an n-bit cyclic code or shortened cyclic code by a simple circuitry without need of high-speed circuits and further an ATM cell synchronization system using a cyclic code.

### DISCLOSURE OF THE INVENTION

The first invention of this application is a method which performs the operation of division on a serially input continuous bit sequence by a generating polynominal successively and detects an n-bit cyclic code or shortened cyclic code contained in the bit sequence by using the result, characterized by subtracting the remainder of division by the generating polynomial before performing the division in advance.

The second invention of this application is a method for detecting an n-bit cyclic code or shortened cyclic code based on a predetermined degree-m generating polynomial G(X),
characterized by subtracting the remainder of division of the (n+1)th bit Xⁿ by said generating polynomial G(X) (remainder of Xⁿ/G(X)) from the remainder of division of the latest n bits (candidate n bits for the bit sequence of the cyclic code) by G(X) if the coefficient of Xⁿ is not 0 each time one bit is input, and determining that the candidate n bits is the cyclic code or shortened cyclic code when the result of the subtraction is zero or a predetermined bit pattern added to the cyclic code.

The third invention of this application is a device for detecting n-bit unit data sequences decoded as a cyclic code or shortened cyclic code based on a degree-m generating polynominal G(X), characterized by comprising
a shift register of an equal to or greater than n-bit stages to which receive bit data is input and
an m-bit divider corresponding to said degree-m generating polynominal G(X), the output of the nth-bit stage of said shift register being input to the exclusive OR circuits put between appropriate stages of said divider, and means for detecting when the individual register contents of said divider are all zero or form a predetermined bit pattern each time one bit of data is input.

### BRIEF DESCRIPTION OF THE DRAWINGS

Figure 1 is the structural diagram of an embodiment into which the ATM cell synchronization of this invention is realized.

Figure 2 is the structural diagram of an 8-bit feedback shift register which functions as a divider.

Figure 3 is the structural diagram for explanation of the problem to be solved.

Figure 4 is the structural diagram of the first method for solving the problem illustrated by Figure 3.

Figure 5 is the structural diagram of the second method for solving the problem illustrated by Figure 3.

### PREFERRED EMBODIMENTS OF THE INVENTION

The present invention is described below in detail, taking for example an embodiment of the present invention applied to the cell synchronization for ATM. This embodiment supposes that the generating polynominal G(X) is 8-bit X⁸ + X² + X + 1, that a cell consists of 5 bytes of header and 48 bytes of information field, 53 bytes in total, and that the header consists of 32-bit information point and 8-bit of HEC.

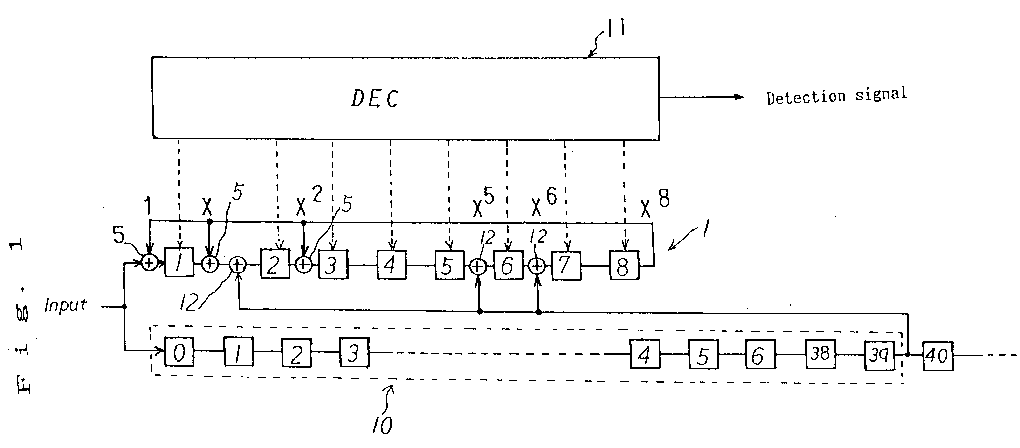

Figure 1 is the structural diagram of the principal part of an embodiment of a cyclic code detecting device for implementing the ATM cell synchronization of this invention. This device has the aforementioned divider 1 with exclusive OR circuits 12 added between the 1st and 2nd stages, the 5th and 6th stages, and the 6th and 7th stages. The output of the last stage of the aforementioned 40-bit shift register 10 is input to the newly added exclusive OR circuits 12, 12, 12. The device comprises a decoder (DEC) 11 for detecting when the values of bits on the divider 1 are all zero or form a predetermined bit pattern.

By this construction, 40 bits of data sequence is divided by generating polynominal ${\text{G(X) = X}}^{\text{8}} {\text{+ X}}^{\text{2}} \text{+ X + 1}$, and the remainder X⁶ + X⁵ + X of X⁴⁰/G(X) is subtracted from the result of the division.

Therefore, when data is input to this circuit bit by bit, the result of the operation by the divider becomes equal to the value subtracted from the divider 1 by the output of the 40-stage shift register and hence the bit values of all stages of the divider 1 become zero if the data held by the 40-stage shift register is the intended data sequence, that is, the cyclic code indicating a boundary.

Therefore, by monitoring the value of the content of each cell of the divider 1 by the decoder DEC 11 and detecting when those contents are all zero, the bit sequence held at that time is the header of the cell.

In other words, by comparison between the remainder of division on the bits of a polynominal of X³⁹ and lower-order terms (40 bits) and that on a polynominal of X³⁹ and lower-order terms with X⁴⁰ added, it is known that the remainder when X⁴⁰ (41st bit) is added becomes the value with the remainder of division of X⁴⁰ by generating polynominal X⁸ + X² + X + 1 (X⁶ + X⁵ + X) added. Therefore, the affection of X⁴⁰ can be eliminated by subtracting X⁶ + X⁵ + X from the divider 1 in advance. Further, by performing the operation of this subtraction each time one bit is shifted, the affection of X⁴⁰ and higher-order terms can be all eliminated, and the output of the divider 1 is always the remainder of the division on 40 bits. This embodiment is not limited to the above example, and the concept can be widely applied.

That is, taking as a generalized case the detection of a n-bit cyclic code or shortened cyclic code based on a degree-m generating polynominal G(X) in a bit sequence input bit by bit, the remainder of division of a n-bit code by the generating polynominal can be always obtained by performing the operation of subtracting the remainder of Xⁿ/G(X) from an n-bit cyclic code or shortened cyclic code each time one bit is input, and hence the position of the boundary of the desired cyclic code or shortened cyclic code can be detected by monitoring this value. Therefore, this invention can be widely used as a method for detecting a predetermined length of cyclic code or shortened cyclic code or a code with a predetermined bit pattern added to them in a continuous bit sequence without being limited to ATM.

As describe above, this embodiment makes it possible to implement a method for detecting the position of an n-bit cyclic code or shortened cyclic code in a continuous bit sequence by means of a simple circuitry without need of high-speed circuits by subtracting the remainder of division of Xⁿ by the generating polynominal from the divider.

Since this invention has the construction and performs the function as described above, it has a remarkable effect of making it possible to detect an n-bit cyclic code or shortened cyclic code in a continuous bit sequence by means of a simple circuitry.

## Claims

1. A method which performs the operation of division on a serially input continuous bit sequence by a generating polynominal successively and detects an n-bit cyclic code or shortened cyclic code contained in the bit sequence by using the result, characterized by subtracting the remainder of division by the generating polynomial before performing the division in advance.

2. A method for detecting an n-bit cyclic code or shortened cyclic code based on a predetermined degree-m generating polynomial G(X), characterized by
subtracting the remainder of division of the (n+1)th bit Xⁿ by said generating polynomial G(X) (remainder of Xⁿ/G(X)) from the remainder of division of the latest n bits (candidate n bits for the bit sequence of the cyclic code) by G(X) if the coefficient of Xⁿ is not 0 each time one bit is input, and
determining that the candidate n bits is the cyclic code or shortened cyclic code when the result of the subtraction is zero or a predetermined bit pattern added to the cyclic code.

3. A device for detecting n-bit unit data sequences decoded as a cyclic code or shortened cyclic code based on a degree-m generating polynominal G(X), characterized by comprising
a shift register of an equal to or greater than n-bit stages to which receive bit data is input and
an m-bit divider corresponding to said degree-m generating polynominal G(X),
the output of the nth-bit stage of said shift register being input to the exclusive OR circuits put between appropriate stages of said divider, and
means for detecting when the individual register contents of said divider are all zero or form a predetermined bit pattern each time one bit of data is input.
